# EUROPÄISCHE PATENTSCHRIFT

(11) **EP 1 873 834 B1**
(45) Veröffentlichungstag und Bekanntmachung des Hinweises auf die Patenterteilung: **10.12.2008**
(21) Anmeldenummer: 06016860.6
(22) Anmeldetag: 11.08.2006
(51) Int. Cl.: H01L 27/146, H04N 3/15

(54) **Löschbarriere, insbesondere für einem Halbleiterdetektor, und zugehöriges Betriebsverfahren**
Reset barrier, especially for a semiconductor detector and corresponding operation method
Barrière de remise à zéro, en particulier pour un détecteur à semiconducteur et méthode d'opération correspondante

(30) Priorität: 29.06.2006 EP 06013518
(43) Veröffentlichungstag der Anmeldung: 02.01.2008
(73) Patentinhaber: Max-Planck-Gesellschaft zur Förderung der Wissenschaften e.V., 80539 München (DE)
(72) Erfinder: Lutz, Gerhard, 81739 München (DE); Richter, Rainer, 81243 München (DE); Strüder, Lothar, 80803 München (DE)
(74) Vertreter: Beier, Ralph

(56) Entgegenhaltungen:
- EP-A- 1 310 999
- EP-A1- 0 538 886
- WO-A-20/05074012
- US-B1- 6 590 611

## Beschreibung

Die Erfindung betrifft eine Halbleiterstruktur, insbesondere in einem Halbleiterdetektor, sowie ein zugehöriges Betriebsverfahren gemäß den nebengeordneten Ansprüche.

Halbleiter-Driftdetektoren zur Strahlungsdetektion sind seit längerem bekannt und beispielsweise in LUTZ, Gerhard: "Semiconductor Radiation Detectors", Springer-Verlag (1999), STRÜDER, Lothar: "Nuclear Instruments and Methods in Physics Research A", Band 454 (2000) und DE 34 27 476 A1, DE 102 13 812 A1 sowie DE 10 2004 004 283 A1 beschrieben. Hierbei erzeugt die zu detektierende Strahlung in einem schwach dotierten, verarmten Halbleitersubstrat Signalelektronen, wobei an einer Oberfläche des Halbleitersubstrats mehrere ringförmige und konzentrisch angeordnete Elektroden angeordnet sind, die in dem Halbleitersubstrat ein Driftfeld erzeugen, durch das die von der Strahlung erzeugten Signalelektronen zu einem mittig angeordneten Ausleseelement driften, das die Signalelektronen und damit die aufgenommene Strahlung detektiert.

Das Ausleseelement kann hierbei aus einem DEPFET-Transistor (DEPFET - Depleted Field Effect Transistor) bestehen, der im Jahre 1984 von J. Kemmer und G. Lutz erfunden wurde und beispielsweise in DE 10 2004 004 283 A1 beschrieben ist.

Ein derartiger DEPFET-Transistor kann ein schwach n-dotiertes, verarmtes Halbleitersubstrat aufweisen, wobei an einer Oberfläche des Halbleitersubstrats eine stark p-dotierte Rückelektrode angeordnet ist, die mit dem schwach n-dotierten Halbleitersubstrat eine in Sperrrichtung gepolte Diode bildet und zur Verarmung des Halbleitersubstrats dient, wobei in dem Halbleitersubstrat durch Strahlungseinwirkung entstandene Löcher über die Rückelektrode aus dem Halbleitersubstrat abgesaugt werden.

An der gegenüberliegenden Oberfläche des Halbleitersubstrats befindet sich bei einem DEPFET-Transistor als Ausleseelement ein stark p-dotiertes Source-Gebiet und ein ebenfalls stark p-dotiertes Drain-Gebiet, wobei sich zwischen dem Source-Gebiet und dem Drain-Gebiet ein Leitungskanal ausbilden kann, dessen Leitfähigkeit durch eine extern ansteuerbare Gate-Elektrode eingestellt werden kann.

Unter dem Leitungskanal befindet sich hierbei in dem Halbleitersubstrat ein schwach n-dotiertes inneres Gate-Gebiet, in dem sich die in dem Halbleitersubstrat durch Strahlungseinwirkung entstandenen Signalelektronen sammeln. Die in dem inneren Gate-Gebiet angesammelte elektrische Ladung steuert die Leitfähigkeit des Leitungskanals zwischen dem Source-Gebiet und dem Drain-Gebiet in ähnlicher Weise wie die externe Gate-Elektrode, so dass der Drain-Source-Strom ein Maß für die detektierte Strahlung ist.

Die in dem inneren Gate-Gebiet angesammelten Signalelektronen müssen jedoch gelegentlich aus dem inneren Gate-Gebiet entfernt werden, um die Empfindlichkeit des Driftdetektors zu erhalten. Hierzu ist bei den bekannten DEPFET-Transistoren ein separater Löschkontakt vorgesehen, der beispielsweise Source-seitig neben dem eigentlichen DEPFET-Transistor angeordnet ist und durch Anlegen einer positiven elektrischen Spannung die in dem inneren Gate-Gebiet angesammelten Signalelektronen absaugt.

Bei dem vorstehend beschriebenen bekannten Halbleiterdetektor ist der Drain-Source-Strom des als Ausleseelement eingesetzten DEPFET-Transistors also ein Maß für die Größe der Signalladung, die von der zu detektierenden Strahlung in dem Halbleitersubstrat erzeugt wurde und in dem inneren Gate-Gebiet des DEPFET-Transistors gesammelt ist. Zur Strahlungsmessung muss der Drain-Source-Strom aber nicht unmittelbar dann gemessen werden, wenn die von der zu detektierenden Strahlung generierte Signalladung in dem inneren Gate-Gebiet des DEPFET-Transistors eintrifft. Es reicht zur Strahlungsmessung vielmehr aus, wenn der Drain-Source-Strom des DEPFET-Transistors zu Beginn eines Messzeitraums und am Ende eines Messzeitraums gemessen wird, wobei der DEPFET-Transistor vor, nach und zwischen den beiden Messungen abgeschaltet werden kann. Die während des Messzeitraums eingefallene Strahlung ergibt sich dann aus der Differenz der beiden Drain-Source-Ströme zu Beginn und am Ende des Messzeitraums. Wegen des elektronischen Rauschens ist es hierbei sinnvoll, die beiden aufeinanderfolgenden Messungen des Drain-Source-Stroms in einem möglichst kurzen Zeitabstand hintereinander zu machen. Dies ist aber beispielsweise bei einem Halbleiterdetektor mit einer Vielzahl von Bildzellen schwierig, da die einzelnen Bildzellen des Halbleiterdetektors hierbei sequenziell ausgelesen werden, so dass zwischen zwei aufeinanderfolgenden Messungen des Drain-Source-Stroms eine vorgegebene Auslese-Zykluszeit liegt, die von der Anzahl der Bildzellen und der Dauer der einzelnen Messvorgänge abhängt. Beispielsweise stellt sich dieses Problem bei Anwendungen in der adaptiven Optik und an dem sogenannten XFEL (X-Ray Free Electron Laser).

Dieses Problem kann dadurch gelöst werden, dass bei einem Auslesevorgang zuerst der Drain-Source-Strom mit in dem inneren Gate-Gebiet gesammelter Ladung gemessen, anschließend das innere Gate-Gebiet vollständig geleert und der Drain-Source-Strom dann nochmals bei geleertem inneren Gate-Gebiet gemessen wird. Schließlich wird dann die Differenz der beiden gemessenen Drain-Source-Ströme als Maß für die zu detektierende Strahlung berechnet.

Bei dieser Meßmethode gibt die erste Messung des Drain-Source-Stroms jedoch nicht nur die Signalladung wieder, die von der zu detektierenden Strahlung in dem Halbleitersubstrat erzeugt wurde und in dem inneren Gate-Gebiet gesammelt ist. Vielmehr enthält die erste Messung des Drain-Source-Stroms auch ein Störsignal, das von thermisch generierter Ladung ("Dunkelstrom") sowie von Streulicht von anderen Objekten herrührt und die Strahlungsmessung verfälscht.

Darüber hinaus werden oftmals Strahlungsereignisse betrachtet, deren genauer Zeitpunkt von vornherein bekannt ist. Dies ist zum Beispiel bei Experimenten mit Teilchenbeschleunigern der Fall, bei denen der Teilchenstrahl eine regelmäßige, pulsförmige Zeitstruktur aufweist. Bei diesen Messungen ist es wünschenswert, die Sensitivität des Halbleiterdetektors auf ein vorgegebenes Zeitfenster zu begrenzen, in dem das interessierende Strahlungsereignis stattfindet. Der Zeitbereich zwischen den einzelnen Strahlungsereignissen kann dann für das Auslesen der gemessenen Signalladungen verwendet werden.

Nachteilig an den vorstehend beschriebenen bekannten Halbleiterdetektoren mit einem DEPFET-Transistor als Ausleseelement ist also die Tatsache, dass die Sensitivität des Halbleiterdetektors gegenüber Störsignalen, wie beispielsweise thermisch generierter Ladung oder Streulicht von anderen Objekten, zeitlich nicht begrenzt werden kann, ohne auch die in dem inneren Gate-Gebiet angesammelten Signalladungsträger zu löschen, die von der interessierenden Strahlung herrühren.

Zum allgemeinen technologischen Hintergrund der Erfindung ist auch hinzuweisen auf US 6 590 611 B1, EP 1 310 999 A und EP 0 538 886 A1.

Der Erfindung liegt deshalb die Aufgabe zugrunde, einen Halbleiterdetektor zu schaffen, der insensitiv geschaltet werden kann, ohne die in dem inneren Gate-Gebiet angesammelten Signalladungsträger zu löschen.

Diese Aufgabe wird erfindungsgemäß dadurch gelöst, dass bei einer bekannten Halbleiterstruktur gemäß DE 10 2004 004 283 A1 zusätzlich ein Barriere-Kontakt vorgesehen ist, der an der Vorderseite des Halbleitersubstrats in lateraler Richtung zwischen dem externen Gate-Gebiet des DEPFET-Transistors und dem Drain-Lösch-Gebiet angeordnet ist, um in dem Halbleitersubstrat zwischen dem inneren Gate-Gebiet und dem Lösch-Kontakt eine steuerbare Potenzialbarriere aufzubauen, die verhindert, dass die in dem inneren Gate-Gebiet angesammelten Ladungsträger von dem Lösch-Kontakt abgesaugt werden.

Der Barriere-Kontakt ermöglicht es vorteilhaft, den Halbleiterdetektor in einen insensitiven Zustand zu schalten, in dem ein positives Potenzial an dem Lösch-Kontakt Signalelektronen aus dem Halbleitersubstrat absaugt, die thermisch generiert wurden oder von störendem Streulicht herrühren, wobei ein negatives Potenzial an dem erfindungsgemäßen Barriere-Kontakt zwischen dem Lösch-Kontakt und dem inneren Gate-Gebiet eine Potenzialbarriere aufbaut, die verhindert, dass das positive Potenzial des Lösch-Kontakts die in dem inneren Gate-Gebiet angesammelten Signalladungsträger absaugt. In diesem insensitiven Zustand des Halbleiterdetektors wird die in dem inneren Gate-Gebiet des DEPFET-Transistors angesammelte Signalladung also gespeichert, wohingegen neu generierte Signalladungsträger von dem Lösch-Kontakt abgesaugt werden und deshalb nicht in das innere Gate-Gebiet gelangen.

Der erfindungsgemäße Halbleiterdetektor eignet sich deshalb besonders vorteilhaft zur Messung von kurzzeitigen Strahlungsereignissen, wie beispielsweise bei den vorstehend erwähnten Experimenten mit Teilchenbeschleunigern, bei denen der Teilchenstrahl eine regelmäßige pulsförmige Zeitstruktur aufweist. Zur Messung der Strahlung in einem eng begrenzten Zeitfenster wird der erfindungsgemäße Halbleiterdetektor dann zunächst in herkömmlicher Weise gelöscht, indem die in dem inneren Gate-Gebiet angesammelten Signalladungsträger über den Lösch-Kontakt abgesaugt werden. Anschließend wird der erfindungsgemäße Halbleiterdetektor dann bis zum Beginn des interessierenden Messzeitraums insensitiv geschaltet, um zu verhindern, dass thermisch generierte Ladungen ("Dunkelstrom") oder störendes Streulicht zwischenzeitlich die Strahlungsmessung verfälschen. Zu Beginn des interessierenden Messzeitraums wird der erfindungsgemäße Halbleiterdetektor dann in einen sensitiven Zustand geschaltet, was in herkömmlicher Weise geschehen kann, wie in der bereits eingangs erwähnten Patentanmeldung DE 10 2004 004 283 A1 beschrieben ist. Nach Ablauf des interessierenden Messzeitraums wird der erfindungsgemäße Halbleiterdetektor dann in herkömmlicher Weise ausgelesen, wobei der gemessene Drain-Source-Strom die in dem inneren Gate-Gebiet des DEPFET-Transistors angesammelte Signalladung wiedergibt. Vorzugsweise wird der erfindungsgemäße Halbleiterdetektor dann nochmals gelöscht, indem in herkömmlicher Weise an den Lösch-Kontakt ein positives Potenzial angelegt wird, so dass die in dem inneren Gate-Gebiet angesammelten Signalladungsträger abgesaugt werden. Schließlich erfolgt dann eine erneute Messung des Drain-Source-Stromes bei leerem inneren Gate-Gebiet. Die während des interessierenden Messzeitraums eingefallene Strahlung ergibt sich dann aus der Differenz der beiden Drain-Source-Ströme.

In einem bevorzugten Ausführungsbeispiel der Erfindung ist das Source-Gebiet des DEPFET-Transistors von dem externen Gate-Gebiet und dem darunter angeordneten inneren Gate-Gebiet umschlossen. Der DEPFET-Transistor ist also bei der erfindungsgemäßen Halbleiterstruktur vorzugsweise ringförmig, wobei das Source-Gebiet innen angeordnet ist.

Darüber hinaus wird das externe Gate-Gebiet vorzugsweise von dem erfindungsgemäßen Barriere-Kontakt umschlossen. Vorzugsweise ist also auch der Barriere-Kontakt ringförmig, wobei das externe Gate-Gebiet und das Source-Gebiet innerhalb des ringförmigen Barriere-Kontakts angeordnet sind.

Ferner wird der Barriere-Kontakt vorzugsweise von dem Drain-Lösch-Gebiet umschlossen, so dass auch das Drain-Lösch-Gebiet ringförmig ist, wobei der Barriere-Kontakt, das externe Gate-Gebiet und das Source-Gebiet innerhalb des Drain-Lösch-Gebiets angeordnet sind. Der im Rahmen der Erfindung verwendete Begriff der Ringförmigkeit ist allgemein zu verstehen und nicht auf kreisringförmige Strukturen beschränkt, sondern umfasst auch ovale und polygonale Strukturen, die beispielsweise rechteckig, quadratisch oder hexagonal sein können. Die Funktionsweise und die Ansteuerung des Drain-Lösch-Gebiets sind in der bereits vorstehend erwähnten Patentanmeldung DE 10 2004 004 283 A1ausführlich beschrieben. Es ist jedoch zu erwähnen, dass das Drain-Lösch-Gebiet bei einem ausreichend negativen Potenzial das Potenzial des Drain-Gebiets bis an das Drain-Ende des Leitungskanals durchstellt und der von dem Source-Gebiet zu dem Drain-Gebiet laufende Strom dann durch das externe Gate-Gebiet und durch die in dem inneren Gate-Gebiet gesammelte Signalladung gesteuert werden kann.

Der Transistorstrom ist dann ein Maß für die in dem inneren Gate-Gebiet befindliche Signalladung. Bei einem positiveren Potenzial an dem Drain-Lösch-Gebiet befindet sich zwischen dem Source-Gebiet und dem Drain-Gebiet des DEPFET-Transistors dagegen kein Leitungskanal, so dass auch kein Drain-Source-Strom fließt. Das Drain-Lösch-Gebiet kann also zusammen mit dem erfindungsgemäßen Barriere-Gebiet dazu verwendet werden, zwischen den folgenden Betriebsarten der erfindungsgemäßen Halbleiterstruktur umzuschalten:
- Zustand I:: Auslesen, d.h. Messen des Drain-Source-Stroms zur Ermittlung der in dem inneren Gate-Gebiet angesammelten Signalladung.
- Zustand II:: Sensitiver Zustand, in dem der Drain-Source-Strom von dem externen Gate-Gebiet unterdrückt wird und Signalladungen in dem inneren Gate-Gebiet gesammelt werden können.
- Zustand III:: Insensitiver Speicherzustand, in dem die in dem inneren Gate-Gebiet gesammelte Signalladung erhalten bleibt, wohingegen neu generierte Signalladungsträger von dem Lösch-Kontakt abgesaugt werden.
- Zustand IV:: Löschen der Halbleiterstruktur, wobei die in dem inneren Gate-Gebiet angesammelten Signalladungsträger von dem Lösch-Kontakt abgesaugt werden.

Die Erfindung ermöglicht also aufgrund des zusätzlichen Barriere-Kontakts erstmals den vorstehend beschriebenen insensitiven Speicherzustand ("Zustand III").

In einem Ausführungsbeispiel der Erfindung ist das Drain-Gebiet an mindestens einer Stelle mit einem Gebiet unter dem Barriere-Kontakt elektrisch leitend verbunden.

Darüber hinaus weisen der Lösch-Kontakt und das Drain-Gebiet in einem Ausführungsbeispiel der Erfindung jeweils mehrere Teilbereiche auf, die im Außenbereich der ringförmigen Halbleiterstruktur in Umfangsrichtung abwechselnd angeordnet sind. Zwischen den benachbarten Bereichen des Löschkontakts einerseits und des Drain-Gebiets andererseits sind hierbei vorzugsweise Zwischenräume angeordnet, um Feldstärkespitzen zu vermeiden.

Weiterhin ist in dem bevorzugten Ausführungsbeispiel der Erfindung ein erstes Abschirm-Gebiet vorgesehen, das in dem Halbleitersubstrat mindestens teilweise unter dem inneren Gate-Gebiet und/oder unter dem Source-Gebiet angeordnet ist. Dieses erste Abschirm-Gebiet soll in dem neuartigen insensitiven Speicher-Zustand verhindern, dass Signalladungsträger, die unterhalb des inneren Gate-Gebiets generiert werden, aufgrund der unmittelbaren Nähe zu dem inneren Gate-Gebiet in das innere Gate-Gebiet gelangen und dort gesammelt werden. Stattdessen bewirkt das erste Abschirm-Gebiet unterhalb des inneren Gate-Gebiets, dass auch solche Ladungsträger, die in dem insensitiven Speicherzustand der Halbleiterstruktur unter dem inneren Gate-Gebiet generiert werden, von dem Lösch-Kontakt abgesaugt werden.

Das erste Abschirm-Gebiet überdeckt das innere Gate-Gebiet in lateraler Richtung hierbei vorzugsweise nur teilweise. Das erste Abschirm-Gebiet weist also vorzugsweise eine geringere laterale Ausdehnung auf als das innere Gate-Gebiet. Dies ist sinnvoll, damit Signalladungsträger, die in dem sensitiven Zustand der Halbleiterstruktur unterhalb des inneren Gate-Gebiets generiert werden, seitlich an dem ersten Abschirm-Gebiet vorbei in das innere Gate-Gebiet gelangen können.

Darüber hinaus weist die erfindungsgemäße Halbleiterstruktur vorzugsweise ein zweites Abschirm-Gebiet auf, das in dem Halbleitersubstrat mindestens teilweise unter dem Lösch-Kontakt angeordnet ist und den Lösch-Kontakt entsprechend abschirmt.

Weiterhin besteht im Rahmen der Erfindung die Möglichkeit, dass das innere Gate-Gebiet teilweise unter dem Source-Gebiet angeordnet ist und entsprechend einem anderen Dotierungstyp dotiert ist als das Source-Gebiet, wobei das Source-Gebiet mit seiner Dotierung bis in das innere Gate-Gebiet hineinreicht und dadurch dessen entgegengesetzte Dotierung teilweise kompensiert. Dadurch wird in dem inneren Gate-Gebiet unterhalb des Source-Gebiets eine Potenzialbarriere aufgebaut, welche die in dem inneren Gate-Gebiet seitlich verdrängt, so dass sich die Signalladungsträger in dem inneren Gate-Gebiet unterhalb des Leitungskanals zwischen dem Source-Gebiet und dem Drain-Gebiet konzentrieren und dadurch den Leitungskanal besser steuern.

Ferner ist zu erwähnen, dass als Halbleitermaterial vorzugsweise Silizium verwendet wird. Die Erfindung ist jedoch hinsichtlich des zu verwendenden Halbleitermaterials nicht auf Silizium beschränkt, sondern auch mit anderen Halbleitermaterialien realisierbar.

Darüber hinaus sind auch andere Isolator- und Leiter-Materialien bei der erfindungsgemäßen Halbleiterstruktur verwendbar.

Es versteht sich hierbei von selbst, dass das vorstehend erwähnte Drain-Lösch-Gebiet vorzugsweise ein MOS-Gebiet ist.

Darüber hinaus ist für den Fachmann klar, dass die erfindungsgemäße Halbleiterstruktur dem Verarmungstyp angehören kann, wobei eine zusätzliche Kanalimplantation vorgesehen ist.

Es ist jedoch alternativ auch möglich, dass die erfindungsgemäße Halbleiterstruktur dem Anreicherungstyp angehört, wobei keine zusätzliche Kanalimplantation erfolgen muss.

Ferner kann das vorstehend erwähnte Drain-Lösch-Gebiet mit einer oberflächennahen oder vergrabenen Implantation des ersten Dotierungstyps unterlegt sein.

Die zusätzliche vergrabene Implantation (z.B. eine n-Dotierung) etwa in der Tiefe des inneren Gate-Gebiets erlaubt einen Elektronentransport in einem Abstand zu der Oberfläche. Dies ist vorteilhaft, weil oberflächennahe Störstellen den Elektronentransport behindern können.

Die zusätzliche oberflächennahe Dotierung bewirkt eine Verschiebung der für den Betrieb der Halbleiterstruktur nötigen Spannungen an dem Drain-Lösch-Gebiet, wodurch diese in einen günstigeren Bereich gebracht werden können. Dies ist insbesondere bei Anreicherungstypen nötig, da sonst die bei Silizium auftretenden positiven Ladungen im Strom-führenden Zustand eine hohe negative Spannung an dem Drain-Lösch-Gebiet erfordern. Natürlich ist es im Rahmen der Erfindung auch möglich, für das externe Gate-Gebiet eine analoge Maßnahme vorzusehen.

Das externe Gate-Gebiet, der erfindungsgemäße Barriere-Kontakt und/oder das Drain-Lösch-Gebiet können beispielsweise aus Polysilizium oder Metall bestehen, jedoch ist die Erfindung auch in anderer Weise realisierbar.

Weiterhin ist zu erwähnen, dass das Halbleitersubstrat vorzugsweise entsprechend einem ersten Dotierungstyp oder entsprechend einem zweiten Dotierungstyp schwach dotiert ist.

Ferner ist zu bemerken, dass das externe Gate-Gebiet, das Source-Gebiet, das Drain-Gebiet, der Lösch-Kontakt und der Barriere-Kontakt bei dem bevorzugten Ausführungsbeispiel der erfindungsgemäßen Halbleiterstruktur elektrisch getrennt ansteuerbar sind.

Bei dem ersten Dotierungstyp kann es sich beispielsweise um eine n-Dotierung handeln, während der zweite Dotierungstyp durch eine p-Dotierung gebildet wird.

Es ist jedoch alternativ auch möglich, dass der erste Dotierungstyp eine p-Dotierung ist, wohingegen es sich bei dem zweiten Dotierungstyp um eine n-Dotierung handelt.

Das Drain-Gebiet und das Source-Gebiet sind vorzugsweise entsprechend dem zweiten Dotierungstyp hoch dotiert, wobei es sich vorzugsweise um eine p⁺-Dotierung handelt.

Das innere Gate-Gebiet ist dagegen vorzugsweise entsprechend dem ersten Dotierungstyp dotiert, wobei es sich vorzugsweise um eine n⁻-Dotierung handelt.

Der Lösch-Kontakt ist dagegen vorzugsweise in dem Halbleitersubstrat auf dessen Vorderseite angeordnet und entsprechend dem ersten Dotierungstyp hochdotiert, wobei es sich vorzugsweise um eine n⁺-Dotierung handelt.

Die beiden vorstehend erwähnten Abschirm-Gebiete zur Abschirmung des inneren Gate-Gebiets bzw. des Lösch-Kontakts sind dagegen vorzugsweise entsprechend dem zweiten Dotierungstyp dotiert, wobei es sich vorzugsweise um eine p-Dotierung handelt.

Ferner ist vorzugsweise an der Rückseite des Halbleitersubstrats ein Gebiet des zweiten Dotierungstyps angeordnet, um das Halbleitersubstrat zu verarmen, wobei dieses Gebiet vorzugsweise p-dotiert ist.

Ferner ist zu erwähnen, dass die Erfindung nicht nur Schutz beansprucht für einen kompletten Halbleiterdetektor zur Strahlungsdetektion, sondern auch auf eine Halbleiterstruktur abstellt, welche die erfindungsgemäßen Merkmale aufweist und in einem Halbleiterdetektor eingesetzt werden kann.

Darüber hinaus umfasst die Erfindung auch ein entsprechendes Betriebsverfahren für einen Halbleiterdetektor, wie sich bereits aus der vorstehenden Beschreibung des erfindungsgemäßen Halbleiterdetektors ergibt und im Folgenden nochmals beschrieben wird.

In einem Schritt des erfindungsgemäßen Betriebsverfahrens erfolgt eine Detektion von Strahlung in einem sensitiven Zustand des Halbleiterdetektors, wobei die Strahlung in dem Halbleitersubstrat des Halbleiterdetektors Signalladungsträger erzeugt, die in dem inneren Gate-Gebiet in dem Halbleitersubstrat gesammelt werden.

In einem weiteren Schritt erfolgt dagegen eine Messung der in dem inneren Gate-Gebiet gesammelten Signalladungsträger als Maß für die detektierte Strahlung.

Ein weiterer Schritt des erfindungsgemäßen Betriebsverfahrens sieht vor, dass die in dem inneren Gate-Gebiet gesammelten Signalladungsträger durch einen Lösch-Kontakt abgesaugt werden.

Die vorstehend beschriebenen Schritte sind bereits aus der Patentanmeldung DE 10 2004 004 283 A1 bekannt, so dass hinsichtlich der technischen Realisierung dieser Schritte auf die vorstehend genannte Patentanmeldung verwiesen wird.

Das erfindungsgemäße Betriebsverfahren weist darüber hinaus einen zusätzlichen Schritt auf, in dem ein insensitiver Zustand des Halbleiterdetektors eingestellt wird, wobei von der Strahlung generierte Signalladungsträger über den Lösch-Kontakt abgeführt werden, während die in dem inneren Gate-Gebiet bereits angesammelten Signalladungsträger dort erhalten bleiben. Bei diesem erfindungsgemäß vorgesehen Zustand handelt es sich also um einen insensitiven Speicherzustand.

Vorzugsweise wird in dem erfindungsgemäß vorgesehenen insensitiven Zustand des Halbleiterdetektors mittels des Barriere-Kontakts eine Potenzialbarriere zwischen dem inneren Gate-Gebiet und dem Lösch-Kontakt erzeugt, wobei die Potenzialbarriere verhindert, dass die in dem inneren Gate-Gebiet gesammelten Signalladungsträger von dem Lösch-Kontakt abgesaugt werden. Zur Erzeugung dieser Potenzialbarriere wird an den Barriere-Kontakt im insensitiven Zustand ein negatives Potenzial angelegt, wohingegen das Potenzial des Barriere-Kontakts zum Löschen der in dem inneren Gate-Gebiet gesammelten Signalladungsträger in positive Richtung verschoben wird, um die Potenzialbarriere zum Löschen abzubauen und dadurch ein Absaugen der in dem inneren Gate-Gebiet gesammelten Ladungsträger durch den Lösch-Kontakt zu ermöglichen.

Beim Messen der in dem inneren Gate-Gebiet angesammelten Ladungsträger wird vorzugsweise entsprechend dem Stand der Technik ein Strom durch einen Leitungskanal zwischen einem Source-Gebiet und einem Drain-Gebiet gemessen, wobei der gemessene Strom von den in dem inneren Gate-Gebiet angesammelten Signalladungsträgern und von dem externen Gate-Gebiet gesteuert wird.

Im sensitiven Zustand wird vorzugsweise an das externe Gate-Gebiet ein solches Potenzial angelegt, dass der Strom durch den Leitungskanal blockiert wird, was jedoch ebenfalls aus dem Stand der Technik gemäß DE 10 2004 004 283 A1 bekannt ist. Diese Blockierung des Leitungskanals im sensitiven Zustand verbessert die Sensitivität des Detektors. Es ist jedoch grundsätzlich auch möglich, dass der Leitungskanal im sensitiven Zustand leitfähig ist.

Zum Löschen und in dem erfindungsgemäß erstmals vorgesehenen insensitiven Zustand des Halbleiterdetektors wird an den Lösch-Kontakt ein positives Potenzial angelegt, welches die in dem Halbleitersubstrat entstehenden Signalladungsträger absaugt.

Das Umschalten zwischen dem erfindungsgemäß erstmals vorgesehenen insensitiven Zustand des Halbleiterdetektors und dem an sich bekannten sensitiven Zustand des Halbleiterdetektors erfolgt vorzugsweise durch eine geeignete elektrische Ansteuerung des Drain-Lösch-Gebiets, wobei das Drain-Lösch-Gebiet wahlweise das Ableiten generierter Signalladungen zu dem Lösch-Kontakt oder die Ausbildung einer mit dem Drain-Gebiet verbundenen Inversionsschicht ermöglicht. Im sensitiven Zustand hat das Drain-Lösch-Gebiet deshalb vorzugsweise ein negatives Potenzial, während das Drain-Lösch-Gebiet in dem erfindungsgemäß erstmals vorgesehenen insensitiven Zustand vorzugsweise mit einem positiven Potenzial angesteuert wird.

Ferner ist zu erwähnen, dass die Erfindung nicht auf ringförmige Strukturen beschränkt ist, sondern auch lineare Strukturen umfasst, die somit ebenfalls in den Schutzbereich fallen.

Andere vorteilhafte Weiterbildungen der Erfindung sind in den Unteransprüchen gekennzeichnet oder werden nachstehend zusammen mit der Beschreibung der bevorzugten Ausführungsbeispiele der Erfindung anhand der Figuren näher erläutert. Es zeigen:
- Figur 1A: eine Aufsichtsdarstellung einer erfindungsgemäßen Halbleiterstruktur,
- Figur 1B: eine Querschnittsdarstellung der Halbleiterstruktur gemäß Figur 1A,
- Figur 2: ein Zeitdiagramm, das die Ansteuerung des Barriere-Kontakts, des Drain-Lösch-Gebiets, des externen Gate-Gebiets und des Lösch-Kontakts verdeutlicht,
- Figur 3: das erfindungsgemäße Betriebsverfahren in Form eines Flussdiagramms,
- Figur 4A: eine Aufsichtsdarstellung eines abgewandelten Ausführungsbeispiels eines erfindungsgemäßen Halbleiterdetektors sowie
- Figur 4B: eine Querschnittsdarstellung des AusführungsbeiSpiels gemäß Figur 4A.

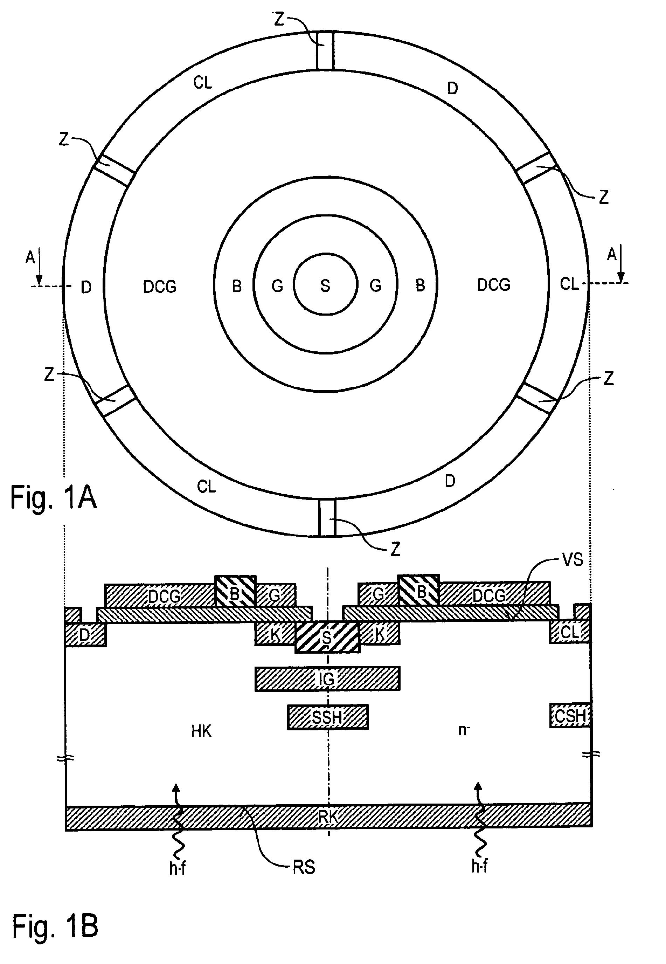

Die in den Figuren 1A und 1B dargestellte DEPFET-Struktur kann als Ausleseelement in einem Driftdetektor eingesetzt werden, wie er beispielsweise in STRÜDER, Lothar: "Nuclear Instruments and Methods in Physics Research A", Band 454 (2000), in LUTZ, Gerhard: "Semiconductor Radiation Detectors", Springer-Verlag (2001) sowie in DE 34 27 476 A1 beschrieben ist.

Die erfindungsgemäße DEPFET-Struktur weist einen schwach n-dotierten plattenförmigen Halbleiterkörper HK auf, der beispielsweise eine Dicke von 300 µm aufweisen kann. Auf einer in der Zeichnung unten liegenden Rückseite RS des Halbleiterkörpers HK ist eine flächige Elektrode RK angeordnet, die aus einem stark p-dotierten Gebiet besteht, wobei die Elektrode RK mit dem Halbleiterkörper HK eine in Sperrrichtung gepolte Diode bildet und zur Verarmung des Halbleiterkörpers HK dient. Im Betrieb der DEPFET-Struktur wird deshalb ein negatives elektrisches Potenzial an die Elektrode RK angelegt, um freie Elektronen aus dem Halbleiterkörper. HK zu entfernen und den Halbleiterkörper HK dadurch zu verarmen.

An einer gegenüber liegenden Vorderseite VS des Halbleiterkörpers HK befindet sich eine Transistorstruktur mit einem stark p-dotierten Source-Gebiet S und einem ebenfalls stark p-dotierten Drain-Gebiet D, wobei sich zwischen dem Source-Gebiet S und dem Drain-Gebiet D ein Leitungskanal K befindet, dessen Leitfähigkeit durch ein externes Gate-Gebiet G gesteuert werden kann, indem ein entsprechendes elektrisches Potenzial an das externe Gate-Gebiet G angelegt wird. Das externe Gate-Gebiet ist hierbei direkt über dem Leitungskanal K angeordnet, damit die Leitfähigkeit des Leitungskanals K von dem externen Gate-Gebiet G möglichst gut gesteuert wird.

Darüber hinaus befindet sich in dem Halbleiterkörper HK unterhalb des Leitungskanals K ein vergrabenes, n-dotiertes inneres Gate-Gebiet IG, in dem sich Signalelektronen sammeln, die aufgrund einer zu detektierenden Strahlungswirkung in dem Halbleiterkörper HK entstehen. Die in dem inneren Gate-Gebiet IG angesammelten Signalelektronen steuern die Leitfähigkeit des Leitungskanals K in ähnlicher Weise wie ein an das externe Gate-Gebiet G angelegtes elektrisches Steuersignal, so dass die Leitfähigkeit des Leitungskanals K ein Maß für die in dem inneren Gate-Gebiet IG angesammelten Signalladungsträger und damit für die eingefallene Strahlung ist.

Das innere Gate-Gebiet IG weist jedoch nur eine begrenzte Aufnahmefähigkeit für die durch Strahlungseinwirkung entstandenen Signalelektronen auf und muss deshalb gelegentlich wieder geleert werden, um die Empfindlichkeit der gesamten DEPFET-Struktur aufrecht zu erhalten. Hierzu ist ein Lösch-Kontakt CL vorgesehen, der aus einem stark n-dotierten Gebiet an der Vorderseite VS des Halbleiterkörpers HK besteht.

Das Drain-Gebiet D und der Lösch-Kontakt CL bestehen jeweils aus drei kreissegmentartigen Bereichen, die im Außenbereich der Halbleiterstruktur über deren Umfang verteilt abwechselnd angeordnet sind, wie aus Figur 1A ersichtlich ist. Zwischen den benachbarten Bereichen des Lösch-Kontakts CL einerseits und des Drain-Gebiets D andererseits sind hierbei jeweils Zwischenräume Z angeordnet, die an den Stoßstellen zwischen dem Lösch-Kontakt CL und dem Drain-Gebiet D Feldstärkespitzen vermeiden sollen.

Die bereits vorstehend erwähnte starke p-Dotierung des Source-Gebiets S wirkt in die Tiefe bis in das innere Gate-Gebiet IG hinein und hat zur Folge, dass die in dem inneren Gate-Gebiet IG angesammelten Signalelektronen unterhalb des Leitungskanals K und nicht unterhalb des Source-Gebiets S konzentriert werden. Dies ist sinnvoll, da die unterhalb des Source-Gebiets S in dem inneren Gate-Gebiet IG befindlichen Elektronen nicht oder nur wenig zur Steuerung der Leitfähigkeit des Leitungskanals K beitragen.

Weiterhin weist die Halbleiterstruktur ein Drain-Lösch-Gebiet DCG auf, das an der Vorderseite VS des Halbleiterkörpers HK angeordnet ist und das externe Gate-Gebiet G ringförmig umgibt. Das Drain-Lösch-Gebiet DCG kann in Abhängigkeit von seiner elektrischen Ansteuerung wahlweise die Löschung des inneren Gate-Gebiets IG durch den Lösch-Kontakt CL unterstützen oder als zusätzliches Drain-Gebiet dienen. Bei genügend negativer Spannung an dem Drain-Lösch-Gebiet DCG übernimmt das Drain-Lösch-Gebiet die Funktion der Drain, während es bei genügend positiven Spannungen an dem Drain-Lösch-Gebiet DCG und an dem Lösch-Kontakt CL das Löschen der in dem inneren Gate-Gebiet IG gespeicherten Signalelektronen ermöglicht.

Eine erfindungsgemäße Besonderheit besteht in einem zusätzlichen Barriere-Kontakt B, der ringförmig zwischen dem Drain-Lösch-Gebiet DCG und dem externen Gate-Gebiet G angeordnet ist und die Einstellung eines sensitiven Speicherzustands der Halbleiterstruktur ermöglicht, in der die in dem Halbleiterkörper HK entstehenden Signalelektronen von dem Lösch-Kontakt CL abgesaugt werden, während die in dem inneren Gate-Gebiet IG angesammelten Signalelektronen erhalten bleiben. Hierzu wird an den Barriere-Kontakt B ein negatives Potenzial angelegt, das in den Halbleiterkörper HK ausstrahlt und zwischen dem inneren Gate-Gebiet IG und dem Lösch-Kontakt CL eine Potenzialbarriere erzeugt, die verhindert, dass die in dem inneren Gate-Gebiet IG angesammelten Signalelektronen von dem positiven Potenzial des Lösch-Kontakts CL abgesaugt werden.

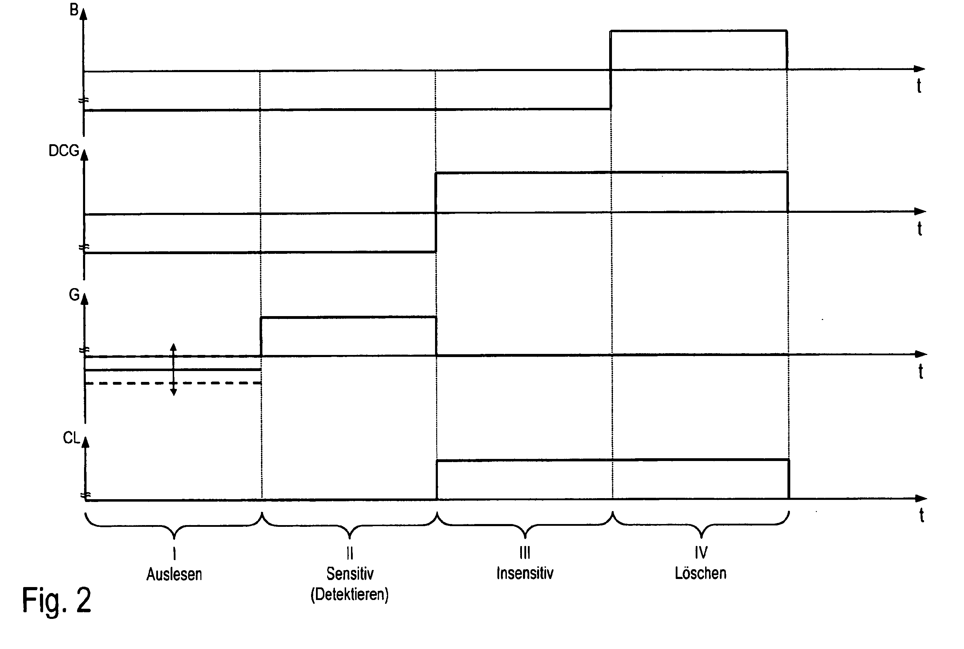

Figur 2 zeigt die verschiedenen Betriebszustände der Halbleiterstruktur gemäß den Figuren 1A und 1B, wobei jeweils die elektrischen Potenziale des Barriere-Kontakts B, des Drain-Lösch-Gebiets DCG, des externen Gate-Gebiets G und des Lösch-Kontakts CL qualitativ dargestellt sind. Vorsorglich wird darauf hingewiesen, dass es sich hierbei lediglich um eine qualitative Darstellung der elektrischen Potenziale handelt, da die tatsächlichen Potenziale unter anderem von der Dotierungsstärke und den geometrischen Abmessungen abhängen.

In einem Zustand I. kann der Halbleiterdetektor ausgelesen werden, wobei die in dem inneren Gate-Gebiet IG angesammelte Ladung ermittelt wird. Hierzu wird an den Barriere-Kontakt B und an das Drain-Lösch-Gebiet jeweils ein negatives Potenzial angelegt. Dadurch bildet sich unter ihnen eine Inversionsschicht aus, die von dem Drain-Gebiet D bis an den Leitungskanal K unter dem externen Gate-Gebiet G heranreicht. Das Potenzial des Drain-Gebiets D wird dann bis an das Drain-Ende des Leitungskanals K durchgestellt und der von dem Source-Gebiet S zu dem Drain-Gebiet D laufende Strom kann durch das externe Gate-Gebiet G und die in dem inneren Gate-Gebiet IG gesammelte Signalladung gesteuert werden, wie durch den Pfeil dargestellt ist. Der Drain-Source-Strom ist dabei ein Maß für die in dem inneren Gate-Gebiet IG befindliche Ladung.

In einem sensitiven Zustand II. detektiert der Halbleiterdetektor dagegen die einfallende Strahlung. Hierzu bleibt an dem Barriere-Kontakt B und an dem Drain-Lösch-Gebiet DCG ein negatives Potenzial angelegt. Das externe Gate-Gebiet G wird dagegen im sensitiven Zustand mit einem positiven Potenzial angesteuert, um den Drain-Source-Strom zu unterdrücken. In diesem Zustand werden die in dem Halbleiterkörper HK generierten Signalladungsträger in dem inneren Gate-Gebiet IG gesammelt.

Darüber hinaus ermöglicht der erfindungsgemäße Halbleiterdetektor einen weiteren Zustand III., in dem der Halbleiterdetektor insensitiv ist. In diesem Zustand wird an den Lösch-Kontakt CL ein positives Potenzial angelegt, um die in dem Halbleiterkörper HK durch Streulicht oder thermische Prozesse generierten freien Ladungsträger zu dem Lösch-Kontakt abzusaugen. An den Barriere-Kontakt B wird dagegen im insensitiven Zustand des Halbleiterdetektors ein negatives Potenzial angelegt, um zwischen dem inneren Gate-Gebiet IG und dem Lösch-Kontakt CL eine Potenzialbarriere aufzubauen, die verhindert, dass das positive Potenzial des Lösch-Kontakts CL die in dem inneren Gate-Gebiet IG angesammelten Signalelektronen absaugt. In diesem insensitiven Zustand liegt an dem Drain-Lösch-Gebiet DCG ebenfalls ein positives Potenzial, so dass kein Drain-Source-Strom zwischen dem Source-Gebiet S und dem Drain-Gebiet D fließen kann.

Schließlich ermöglicht der erfindungsgemäße Halbleiterdetektor noch einen herkömmlichen Zustand IV., in dem die angesammelte Signalladung gelöscht wird. In diesem Zustand wechselt der Barriere-Kontakt B auf ein positives Potenzial, um die Potenzialbarriere zwischen dem inneren Gate-Gebiet IG und dem Lösch-Kontakt CL abzubauen, so dass der Lösch-Kontakt CL die in dem inneren Gate-Gebiet IG angesammelten Signalelektronen absaugen und den Halbleiterdetektor dadurch löschen kann.

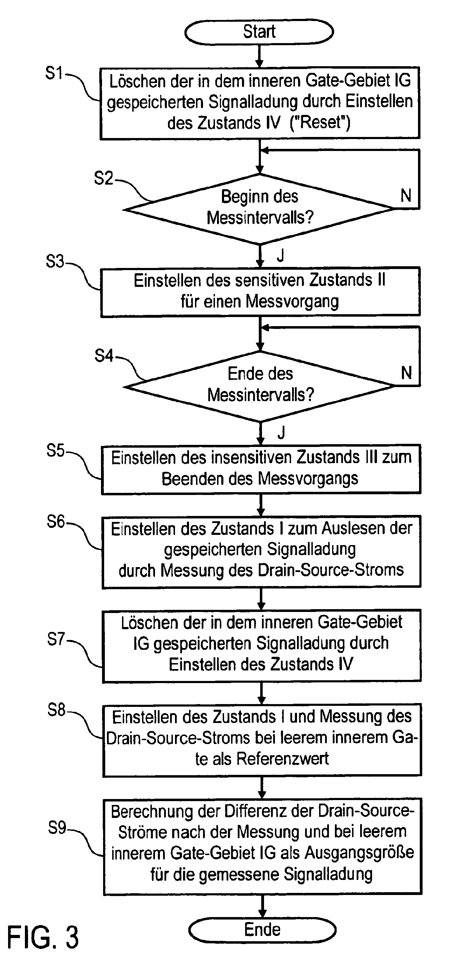

Figur 3 zeigt ein Ausführungsbeispiel eines erfindungsgemäßen Betriebsverfahrens für den vorstehend beschriebenen erfindungsgemäßen Halbleiterdetektor. Dieses Betriebsverfahren eignet sich besonders vorteilhaft zur Detektion von kurzen Strahlungsereignissen, deren Zeitpunkt im vornherein bekannt ist, wie es beispielsweise bei Experimenten mit Teilchenbeschleunigern der Fall ist.

In einem ersten Schritt S1 wird zunächst der vorstehend beschriebene Zustand IV. eingestellt, in dem die in dem inneren Gate-Gebiet IG gespeicherten Signalladungen gelöscht werden.

Anschließend wird dann in einem weiteren Schritt S2 laufend geprüft, ob das interessierende Messintervall begonnen hat, wobei der Zustand IV. bis zu Beginn des Messintervalls beibehalten wird.

Zu Beginn des interessierenden Messintervalls wird dann in einem Schritt S3 der vorstehend beschriebene sensitive Zustand II. des Halbleiterdetektors eingestellt, in dem die einfallende Strahlung Signalelektronen generiert, die in dem inneren Gate-Gebiet IG gesammelt werden.

Dabei wird in einem weiteren Schritt S4 laufend überprüft, ob das Ende des interessierenden Messintervalls erreicht ist.

Am Ende des interessierenden Messintervalls wird dann in einem weiteren Schritt S5 der vorstehend beschriebene erfindungsgemäße insensitive Zustand III. des Halbleiterdetektors eingestellt, in dem die einfallende Strahlung zwar noch Signalelektronen in dem Halbleiterkörper HK generiert, die jedoch von dem Lösch-Kontakt CL abgesaugt werden und deshalb nicht in das innere Gate-Gebiet IG gelangen.

Anschließend wird dann in einem weiteren Schritt S6 der vorstehend beschriebene Zustand I. eingestellt, in dem die in dem inneren Gate-Gebiet IG gesammelte Signalladung ausgelesen wird, wobei der Drain-Source-Strom gemessen wird.

Anschließend erfolgt dann in einem weiteren Schritt S7 eine Löschung der in dem inneren Gate-Gebiet IG gespeicherten Signalladung durch Einstellen des vorstehend erläuterten Zustands IV., in dem der Lösch-Kontakt CL die in dem inneren Gate-Gebiet IG gesammelten Signalelektronen absaugt.

Nach dieser Löschung wird dann erneut der vorstehend beschriebene Zustand I. in einem Schritt S8 eingestellt, und es erfolgt eine erneute Messung des Drain-Source-Stroms bei leerem innerem Gate-Gebiet IG.

In einem letzten Schritt S9 wird dann schließlich die Differenz der beiden gemessenen Drain-Source-Ströme berechnet, die ein Maß für die während des interessierenden Messintervalls eingefallene Strahlung bildet.

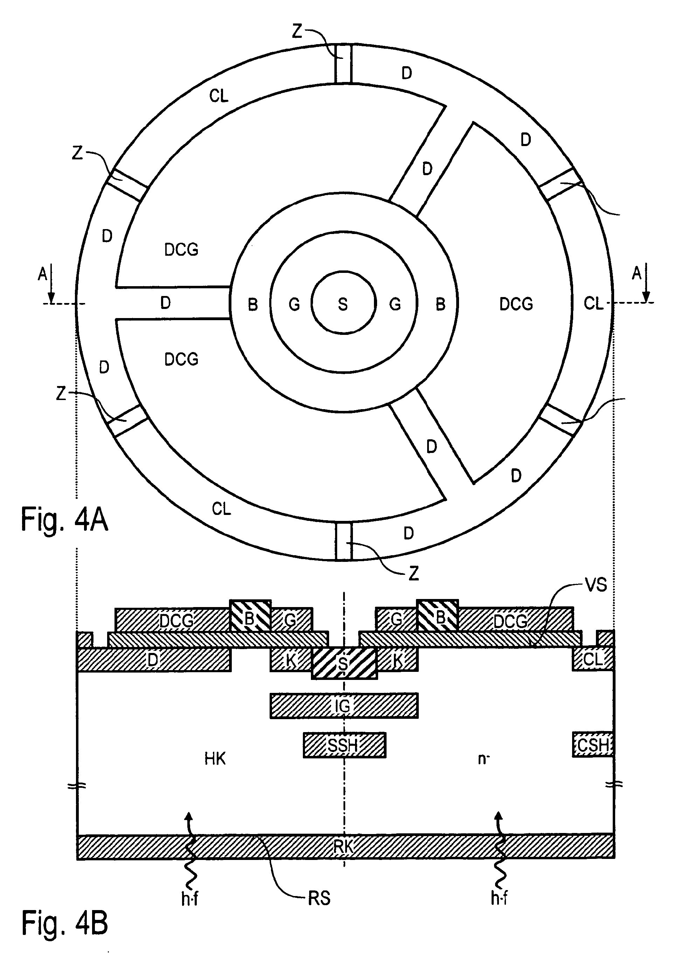

Die Figuren 4A und 4B zeigen eine Abwandlung des Ausführungsbeispiels aus den Figuren 1A und 1B, wobei dieses Ausführungsbeispiel weitgehend mit dem vorstehend beschriebenen Ausführungsbeispiel übereinstimmt. Zur Vermeidung von Wiederholungen wird deshalb weitgehend auf die vorstehende Beschreibung verwiesen, wobei für entsprechende Teile bzw. Bereiche dieselben Bezugszeichen verwendet werden.

Eine Besonderheit dieses Ausführungsbeispiels besteht darin, dass das Drain-Gebiet D radiale Ausläufer aufweist, die in radialer Richtung bis an den Barriere-Kontakt B herangeführt sind.

Ein Vorteil dieser Anordnung besteht darin, dass auch während des Auslesens (Zustand I) das Sammeln von zusätzlicher Ladung unterdrückt werden kann. In diesem Zustand I kann das Drain-Lösch-Gebiet DCG sich auch im positiven Zustand befinden, da die Inversionsschicht unter dem Barriere-Kontakt B leitend mit dem Drain-Gebiet D verbunden ist.

Die Erfindung ist nicht auf die vorstehend beschriebenen bevorzugten Ausführungsbeispiele beschränkt. Vielmehr ist eine Vielzahl von Varianten und Abwandlungen möglich, die ebenfalls von dem Erfindungsgedanken Gebrauch machen und deshalb in den Schutzbereich fallen.

### Bezugszeichenliste:

- B: Barriere-Kontakt
- CL: Lösch-Kontakt
- CSH: Abschirmgebiet
- D: Drain-Gebiet
- DCG: Drain-Lösch-Kontakt
- G: Externes Gate-Gebiet
- HK: Halbleiterkörper
- IG: Inneres Gate-Gebiet
- K: Leitungskanal
- RS: Rückseite
- S: Source-Gebiet
- SSH: Abschirm-Gebiet
- VS: Vorderseite
- Z: Zwischenraum

## Patentansprüche

1. Halbleiterstruktur, insbesondere in einem Halbleiterdetektor, mit
a) einem Halbleitersubstrat (HK) mit einer Vorderseite (VS) und einer Rückseite (RS),
b) einem an der Vorderseite (VS) des Halbleitersubstrats (HK) angeordneten Source-Gebiet (S),
c) einem an der Vorderseite (VS) des Halbleitersubstrats (HK) angeordneten Drain-Gebiet (D),
d) einem an der Vorderseite (VS) des Halbleitersubstrats (HK) angeordneten externen Gate-Gebiet (G), das zur Steuerung eines darunter liegenden Leitungskanals (K) dient,
e) einem inneren Gate-Gebiet (IG) zur Sammlung von freien Ladungsträgern, die in dem Halbleitersubstrat (HK) generiert wurden, wobei das innere Gate-Gebiet (IG) in dem Halbleitersubstrat (HK) mindestens teilweise unter dem externen Gate-Gebiet (G) angeordnet ist, um den Leitungskanal (K) in Abhängigkeit von den gesammelten Ladungsträgern von unten zu steuern,
f) einem Lösch-Kontakt (CL) zur Entfernung der angesammelten Ladungsträger aus dem inneren Gate-Gebiet (IG),
g) einem Drain-Lösch-Gebiet (DCG), das wahlweise als Hilfslösch-Kontakt oder als Drain ansteuerbar ist, wobei das Drain-Lösch-Gebiet (DCG) an der Vorderseite (VS) des Halbleitersubstrats (HK) angeordnet ist,
**gekennzeichnet durch**
h) einen zusätzlichen Barriere-Kontakt (B), der an der Vorderseite (VS) des Halbleitersubstrats (HK) in lateraler Richtung zwischen dem externen Gate-Gebiet (G) und dem Drain-Lösch-Gebiet (DCG) angeordnet ist, um eine steuerbare Potentialbarriere zwischen dem inneren Gate-Gebiet (IG) und dem Lösch-Kontakt (CL) aufzubauen, die verhindert, dass die in dem inneren Gate-Gebiet (IG) angesammelten Ladungsträger von dem Lösch-Kontakt (CL) abgesaugt werden.

2. Halbleiterstruktur nach Anspruch 1, **dadurch gekennzeichnet,**
a) **dass** das Source-Gebiet (S) von dem externen Gate-Gebiet (G) und dem darunter angeordneten inneren Gate-Gebiet (IG) umschlossen wird und/oder
b) **dass** das externe Gate-Gebiet (G) von dem Barriere-Kontakt (B) umschlossen wird und/oder
c) **dass** der Barriere-Kontakt (K) von dem Drain-Lösch-Gebiet (DCG) umschlossen wird.

3. Halbleiterstruktur nach einem der vorhergehenden Ansprüche, **dadurch gekennzeichnet, dass** an mindestens einer Stelle das Drain-Gebiet (D) mit einem Gebiet unter dem Barriere-Kontakt (B) elektrisch leitend verbunden ist.

4. Halbleiterstruktur nach einem der vorhergehenden Ansprüche, **dadurch gekennzeichnet, dass** der Lösch-Kontakt (CL) und das Drain-Gebiet (D) im Außenbereich der Halbleiterstruktur abwechselnd angeordnet werden.

5. Halbleiterstruktur nach Anspruch 4, **dadurch gekennzeichnet, dass** zwischen den benachbarten Bereichen des Lösch-Kontakts (CL) und des Drain-Gebiets (D) Zwischenräume (Z) angeordnet sind, um Feldstärkespitzen zu vermeiden.

6. Halbleiterstruktur nach einem der vorhergehenden Ansprüche, **gekennzeichnet durch** ein erstes Abschirm-Gebiet (SSH), das in dem Halbleitersubstrat (HK) mindestens teilweise unter dem inneren Gate-Gebiet (IG) und/oder unter dem Source-Gebiet (S) angeordnet ist.

7. Halbleiterstruktur nach Anspruch 6, **dadurch gekennzeichnet, dass** das erste Abschirm-Gebiet (SSH) das innere Gate-Gebiet (IG) in lateraler Richtung nur teilweise überdeckt.

8. Halbleiterstruktur nach einem der vorhergehenden Ansprüche, **gekennzeichnet durch** ein zweites Abschirm-Gebiet (CSH), das in dem Halbleitersubstrat (HK) mindestens teilweise unter dem Lösch-Kontakt (CL) angeordnet ist.

9. Halbleiterstruktur nach einem der vorhergehenden Ansprüche, **dadurch gekennzeichnet, dass** das innere Gaze-Gebiet (IG) teilweise unter dem Source-Gebiet (S) angeordnet ist und entsprechend einem anderen Dotierungstyp dotiert ist als das Source-Gebiet (S), wobei das Source-Gebiet (S) mit seiner Dotierung bis in das innere Gate-Gebiet (IG) hineinreicht und dadurch dessen entgegen gesetzte Dotierung teilweise kompensiert.

10. Halbleiterstruktur nach einem der vorhergehenden Ansprüche, **dadurch gekennzeichnet, dass** das Halbleitersubstrat (HK) Silizium ist.

11. Halbleiterstruktur nach einem der vorhergehenden Ansprüche, **dadurch gekennzeichnet, dass** das Drain-Lösch-Gebiet (DCG), der Barriere-Kontakt (B) und/oder das externe Gate-Gebiet (G) mindestens teilweise aus Metall oder Polysilizium bestehen.

12. Halbleiterstruktur nach einem der vorhergehenden Ansprüche, **dadurch gekennzeichnet, dass**
a) das Halbleitersubstrat (HK) entsprechend einem ersten Dotierungstyp (n⁻) oder entsprechend einem zweiten Dotierungstyp (p⁻) schwach dotiert ist und/oder
b) das Drain-Gebiet (D) entsprechend dem zweiten Dotierungstyp (p⁺) hoch dotiert ist und/oder
c) das Source-Gebiet (S) entsprechend dem zweiten Dotierungstyp (p⁺) hoch dotiert ist und/oder
d) das innere Gate-Gebiet (IG) entsprechend dem ersten Dotierungstyp (n⁻) dotiert ist und/oder
e) der Lösch-Kontakt (CL) in dem Halbleitersubstrat (HK) an dessen Vorderseite (VS) angeordnet und entsprechend dem ersten Dotierungstyp (n⁺) hoch dotiert ist und/oder
f) das erste Abschirm-Gebiet (SSH) entsprechend dem zweiten Dotierungstyp (p) dotiert ist und/oder
g) das zweite Abschirm-Gebiet (CSH) entsprechend dem zweiten Dotierungstyp (p) dotiert ist und/oder
h) an der Rückseite (RS) des Halbleitersubstrats (HK) ein Gebiet (RK) des zweiten Dotierungstyps (p) angeordnet ist, um das Halbleitersubstrat (HK) zu verarmen.

13. Halbleiterstruktur nach Anspruch 12, **dadurch gekennzeichnet, dass** der erste Dotierungstyp n-dotiert ist, wohingegen der zweite Dotierungstyp p-dotiert ist.

14. Halbleiterstruktur nach Anspruch 12, **dadurch gekennzeichnet, dass** der erste Dotierungstyp p-dotiert ist, wohingegen der zweite Dotierungstyp n-dotiert ist.

15. Halbleiterdetektor mit einer Halbleiterstruktur nach einem der vorhergehenden Ansprüche.

16. Betriebsverfahren für einen Halbleiterdetektor nach einem der vorhergehenden Ansprüche, mit folgenden Schritten (S3, S6, S7) in beliebiger Reihenfolge:
a) Detektion von Strahlung in einem sensitiven Zustand des Halbleiterdetektors, wobei die Strahlung in einem Halbleitersubstrat (HK) des Halbleiterdetektors Signalladungsträger erzeugt, die in einem inneren Gate-Gebiet (IG) in dem Halbleitersubstrat (HK) gesammelt werden,
b) Messen der in dem inneren Gate-Gebiet (IG) gesammelten Signalladungsträger als Maß für die detektierte Strahlung,
c) Löschen der in dem inneren Gate-Gebiet (IG) gesammelten Signalladungsträger durch einen Lösch-Kontakt (CL),
d) Einstellen eines insensitiven Zustands des Halbleiterdetektors, in dem von der Strahlung generierte Signalladungsträger über den Lösch-Kontakt (CL) abgeführt werden, während die in dem inneren Gate-Gebiet (IG) bereits angesammelten Signalladungsträger dort erhalten bleiben.

17. Betriebsverfahren nach Anspruch 16, **dadurch gekennzeichnet, dass** in dem insensitiven Zustand des Halbleiterdetektors mittels des Barriere-Kontakts (B) eine Potentialbarriere zwischen dem inneren Gate-Gebiet (IG) und dem Lösch-Kontakt (CL) erzeugt wird, wobei die Potentialbarriere verhindert, dass die in dem inneren Gate-Gebiet (IG) gesammelten Signalladungsträger von dem Lösch-Kontakt (CL) abgesaugt werden.

18. Betriebsverfahren nach Anspruch 17, **dadurch gekennzeichnet,**
a) **dass** an den Barriere-Kontakt (B) im insensitiven Zustand ein negatives Potential angelegt wird, um die Potentialbarriere zwischen dem inneren Gate-Gebiet (IG) und dem Lösch-Kontakt (CL) zu erzeugen, und
b) **dass** das Potential des Barriere-Kontakts (B) zum Löschen der in dem inneren Gate-Gebiet (IG) gesammelten Signalladungsträger in positive Richtung verschoben wird, um die Potentialbarriere abzubauen und ein Absaugen der in dem inneren Gate-Gebiet (IG) gesammelten Signalladungsträger zu ermöglichen.

19. Betriebsverfahren nach einem der Ansprüche 16 bis 18, **dadurch gekennzeichnet, dass** beim Messen der in dem inneren Gate-Gebiet (IG) angesammelten Signalladungsträger ein Strom durch einen Leitungskanal (K) zwischen einem Source-Gebiet (S) und einem Drain-Gebiet (D) in dem Halbleitersubstrat (HK) gemessen wird, wobei der gemessene Strom von den in dem inneren Gate-Gebiet (IG) angesammelten Signalladungsträgern und von einem externen Gate-Gebiet (G) gesteuert wird.

20. Betriebsverfahren nach Anspruch 19, **dadurch gekennzeichnet, dass** an das externe Gate-Gebiet (G) im sensitiven Zustand ein solches Potential angelegt wird, dass der Strom durch den Leitungskanal (K) blockiert wird.

21. Betriebsverfahren nach einem der Ansprüche 16 bis 20, **dadurch gekennzeichnet, dass** an den Lösch-Kontakt (CL) während des Löschens und im insensitiven Zustand ein positives Potential angelegt wird.

22. Betriebsverfahren nach einem der Ansprüche 16 bis 21, **dadurch gekennzeichnet, dass** zum Umschalten zwischen dem insensitiven Zustand und dem sensitiven Zustand ein an der Vorderseite (VS) des Halbleitersubstrats (HK) befindliches Drain-Lösch-Gebiet (DCG) angesteuert wird, das wahlweise das Ableiten generierter Signalladung zu dem Löschkontakt (CL) oder die Ausbildung einer mit dem Drain-Gebiet (D) verbundenen Inversionsschicht ermöglicht.

23. Betriebsverfahren nach Anspruch 22, **dadurch gekennzeichnet, dass** das Drain-Lösch-Gebiet (DCG) im sensitiven Zustand mit einem negativen Potential und im insensitiven Zustand mit einem positiven Potential angesteuert wird.

24. Betriebsverfahren nach einem der Ansprüche 16 bis 23, **gekennzeichnet durch** folgende Sequenz zur Detektion der in einem vorgegebenen Detektionszeitraum einfallenden Strahlung:
a) Löschen der in dem inneren Gate-Gebiet (IG) angesammelten Signalladungsträger bis zum Beginn des Detektionszeitraums,
b) Detektion der einfallenden Strahlung während des Detektionszeitraums,
c) Einstellen des insensitiven Zustands zum Ende des Detektionszeitraums,
d) Messen des Stroms zwischen dem Source-Gebiet (S) und dem Drain-Gebiet (D) als Maß für die in dem Gate-Gebiet (IG) angesammelten Signalladungsträger,
e) Löschen der in dem inneren Gate-Gebiet (IG) angesammelten Signalladungsträger,
f) Messen des Stroms zwischen dem Source-Gebiet (S) und dem Drain-Gebiet (D) als Referenzgröße,
g) Berechnung der Differenz der beiden gemessenen Ströme.

## Claims

1. Semiconductor structure, particularly in a semiconductor detector, comprising
a) a semiconductor substrate (HK) with a front side (VS) and a back side (RS),
b) a source region (S) arranged on the front side (VS) of the semiconductor substrate (HK),
c) a drain region (D) arranged on the front side (VS) of the semiconductor substrate (HK),
d) an external gate region (G) arranged on the front side (VS) of the semiconductor substrate (HK) that serves to control a conduction channel (K) located underneath it,
e) an inner gate region (IG) for collecting free charge carriers that are generated in the semiconductor substrate (HK), wherein the inner gate region (IG) is arranged in the semiconductor substrate (HK) at least partially below the external gate region (G) in order to control the conduction channel (K) from below as a function of the accumulated charge carriers,
f) a clear contact (CL) for removing the accumulated charge carriers from the inner gate region (IG),
g) a drain-clear region (DCG) that can be selectively controlled as an auxiliary clear contact or as a drain, which drain-clear region (DCG) is arranged on the front side (VS) of the semiconductor substrate (HK),
**characterized by**
h) an additional barrier contact (B) that is arranged on the front side (VS) of the semiconductor substrate (HK) in the lateral direction between the external gate region (G) and the drain-clear region (DCG) in order to build up a controllable potential barrier between the inner gate region (IG) and the clear contact (CL) that prevents the charge carriers accumulated in the inner gate region (IG) from being removed by suction from the clear contact (CL).

2. Semiconductor structure according to Claim 1,
**characterized in that**
a) the source region (S) is surrounded by the external gate region (G) and the inner gate region (IG) arranged underneath it, and/or
b) the external gate region (G) is surrounded by the barrier contact (B), and/or
c) the barrier contact (B) is surrounded by the drain-clear region (DCG).

3. Semiconductor structure according to any of the preceding claims, **characterized in that** the drain region (D) is connected in an electrically conductive manner at at least one location to a region under the barrier contact (B).

4. Semiconductor structure according to any of the preceding claims, **characterized in that** the clear contact (CL) and the drain region (D) are alternately arranged in the outer region of the semiconductor structure.

5. Semiconductor structure according to Claim 4, **characterized in that** intermediate spaces are arranged between the adjacent zones of the clear contact (CL) and of the drain region (D) in order to avoid field strength peaks.

6. Semiconductor structure according to any of the preceding claims, **characterized by** a first shielding region (SSH) arranged in the semiconductor substrate (HK) at least partially under the inner gate region (IG) and/or under the source region (S).

7. Semiconductor structure according to Claim 6, **characterized in that** the first shielding region (SSH) only partially covers the inner gate region (IG) in the lateral direction.

8. Semiconductor structure according to any of the preceding claims, **characterized by** a second shielding region (CSH) arranged in the semiconductor substrate (HK) at least partially under the clear contact (CL).

9. Semiconductor structure according to any of the preceding claims, **characterized in that** the inner gate region (IG) is arranged partially below the source region (S) and is doped according to a different doping type than the source region (S), wherein the source region (S) extends with its doping into the inner gate region (IG) and as a result compensates its opposed doping at least partially.

10. Semiconductor structure according to any of the preceding claims, **characterized in that** the semiconductor substrate (HK) is silicon.

11. Semiconductor structure according to any of the preceding claims, **characterized in that** the drain-clear region (DCG), the barrier contact (B) and/or the external gate region (G) consist at least partially of metal or polysilicon.

12. Semiconductor structure according to any of the preceding claims, **characterized in that**
a) the semiconductor substrate (HK) is weakly doped in accordance with a first doping type (n⁻) or a second doping type (p⁻), and/or
b) the drain region (D) is highly doped according to the second doping type (p⁺), and/or
c) the source region (S) is highly doped according to the second doping type (p⁺), and/or
d) the inner gate region (IG) is doped according to the first doping type (n⁻), and/or
e) the clear contact (CL) is arranged in the semiconductor substrate (HK) on its front side (VS) and is highly doped according to the first doping type (n⁺), and/or
f) the first shielding region (SSH) is doped according to the second doping type (p), and/or
g) the second shielding region (CSH) is doped according to the second doping type (p), and/or
h) a region of the second doping type (p) is arranged on the back side (RS) of the semiconductor substrate (HK) in order to deplete the semiconductor substrate (HK).

13. Semiconductor structure according to Claim 12, **characterized in that** the first doping type is n-doped, in contrast to which the second doping type is p-doped.

14. Semiconductor structure according to Claim 12, **characterized in that** the first doping type is p-doped, in contrast to which the second doping type is n-doped.

15. Semiconductor detector comprising a semiconductor structure according to any of the preceding claims.

16. Operating method for a semiconductor detector according to any of the preceding claims, comprising the following steps (S3, S6, S7) in any sequence:
a) Detection of radiation in a sensitive state of the semiconductor detector, wherein the radiation generates signal charge carriers in a semiconductor substrate (HK) of the semiconductor detector, which accumulate in an inner gate region (IG) in the semiconductor substrate (HK),
b) measuring of the signal charge carriers accumulated in the inner gate region (IG) as a measure for the detected radiation,
c) clearing of the signal charge carriers accumulated in the inner gate region (IG) by a clear contact (CL),
d) adjustment of an insensitive state of the semiconductor detector in which signal charge carriers generated by the radiation are removed via the clear contact (CL) while the signal charge carriers already accumulated in the inner gate region (IG) remain preserved there.

17. Operating method according to Claim 16, **characterized in that** a potential barrier between the inner gate region (IG) and the clear contact (CL) is generated in the insensitive state of the semiconductor detector by the barrier contact (B) which potential barrier prevents the signal charge carriers accumulated in the inner gate region (IG) from being removed by suction from the clear contact (CL).

18. Operating method according to Claim 17, **characterized in that**
a) a negative potential is applied to the barrier contact (B) in the insensitive state in order to generate the potential barrier between the inner gate region (IG) and the clear contact (CL), and
b) the potential of the barrier contact (B) for clearing the signal charge carriers accumulated in the inner gate region (IG) is shifted in a positive direction in order to break down the potential barrier and make possible a suction removal of the signal charge carriers accumulated in the inner gate region (IG).

19. Operating method according to one of Claims 16 to 18, **characterized in that** when measuring the signal charge carriers accumulated in the inner gate region (IG) a current through a conduction channel (K) between a source region (S) and a drain region (D) is measured in the semiconductor detector, wherein the measured current is controlled by the signal charge carriers collected in the inner gate region (IG) and by an external gate region (G).

20. Operating method according to Claim 19, **characterized in that** such a potential is applied to the external gate region (G) in the sensitive state that the current through the conduction channel (K) is blocked.

21. Operating method according to any of claims 16 to 20, **characterized in that** a positive potential is applied to the clear contact (CL) during the clearing and in the insensitive state.

22. Operating method according to any of claims 16 to 21, **characterized in that** in order to switch between the insensitive state and the sensitive state a drain-clear region (DCG) located on the front side (VS) of the semiconductor substrate (HK) is controlled that selectively makes possible the discharge of a generated signal charge to the clear contact (CL) or the formation of an inversion layer connected to the drain region (D).

23. Operating method according to Claim 22, **characterized in that** the drain-clear region (DCG) is controlled in the sensitive state with a negative potential and in the insensitive state with a positive potential.

24. Operating method according to any of claims 16 to 23, **characterized by** the following sequence for the detection of incident radiation in a given detection time period:
a) Clearing of the signal charge carriers accumulated in the inner gate region (IG) up to the beginning of the detection time period,
b) detection of the incident radiation during the detection time period,
c) adjustment of the insensitive state at the end of the detection time period,
d) measuring of the current between the source region (S) and the drain region (D) as a measure for the signal charge carriers accumulated in the gate region,
e) clearing of the signal charge carriers accumulated in the inner gate region (IG),
f) measuring of the current between the source region (S) and the drain region (D) as a reference magnitude,
g) calculation of the difference of the two measured currents.

## Revendications

1. Structure de semi-conducteur, en particulier dans un détecteur à semi-conducteur, avec
a) un substrat semi-conducteur (HK) avec une face avant (VS) et une face arrière (RS),
b) une zone de source (S) disposée contre la face avant (VS) du substrat semi-conducteur (HK),
c) une zone de drain (D) disposée contre la face avant (VS) du substrat semi-conducteur (HK),
d) une zone de porte externe (G) disposée contre la face avant (VS) du substrat semi-conducteur (HK), laquelle sert à la commande d'une canalisation de ligne (K) disposée en-dessous,
e) une zone de porte interne (IG) pour l'accumulation de porteurs de charge libres générés dans le substrat semi-conducteur (HK), la zone de porte interne (IG) dans le substrat semi-conducteur (HK) étant disposée au moins en partie sous la zone de porte externe (G) pour commander par le bas la canalisation de ligne (K) en fonction des porteurs de charge accumulés,
f) un contact d'extinction (CL) pour la suppression des porteurs de charge accumulés sur la zone de porte interne (IG),
g) une zone d'extinction de drain (DCG) pouvant être excitée en option comme contact d'extinction auxiliaire ou comme drain, ladite zone d'extinction de drain (DCG) étant disposée contre la face avant (VS) du substrat semi-conducteur (HK),
**caractérisée par**
h) un contact à barrière (B) additionnel, disposé contre la face avant (VS) du substrat semi-conducteur (HK) entre la zone de porte externe (G) et la zone d'extinction de drain (DCG) en direction latérale, pour créer une barrière de potentiel excitable entre la zone de porte interne (IG) et le contact d'extinction (CL), laquelle empêche l'aspiration par le contact d'extinction (CL) des porteurs de charge accumulés dans la zone de porte interne (IG).

2. Structure de semi-conducteur selon la revendication 1, **caractérisée en ce que :**
a) la zone de source (S) est entourée par la zone de porte externe (G) et la zone de porte interne (IG) et / ou
b) la zone de porte externe (G) est entourée par le contact à barrière (B) et / ou
c) le contact à barrière (K) est entouré par la zone d'extinction de drain (DCG).

3. Structure de semi-conducteur selon l'une quelconque des revendications précédentes, **caractérisée en ce qu'**à un emplacement au moins, la zone de drain (D) est raccordée de manière à réaliser une conduction électrique avec une zone sous le contact à barrière (B).

4. Structure de semi-conducteur selon l'une quelconque des revendications précédentes, **caractérisée en ce que** le contact d'extinction (CL) et la zone de drain (D) sont disposés de manière alternée sur la partie extérieure de la structure de semi-conducteur.

5. Structure de semi-conducteur selon la revendication 4, **caractérisée en ce que** des interstices (Z) sont ménagés entre les parties contiguës du contact d'extinction (CL) et de la zone de drain (D), pour éviter des crêtes d'intensité de champ.

6. Structure de semi-conducteur selon l'une quelconque des revendications précédentes, **caractérisée par** une première zone de blindage (SSH) disposée dans le substrat semi-conducteur (HK), au moins partiellement sous la zone de porte interne (IG) et / ou sous la zone de source (S).

7. Structure de semi-conducteur selon la revendication 6, **caractérisée en ce que** la première zone de blindage (SSH) ne recouvre que partiellement la zone de porte interne (IG) en direction latérale.

8. Structure de semi-conducteur selon l'une quelconque des revendications précédentes, **caractérisée par** une deuxième zone de blindage (CSH) disposée dans le substrat semi-conducteur (HK), au moins partiellement sous le contact d'extinction (CL).

9. Structure de semi-conducteur selon l'une quelconque des revendications précédentes, **caractérisée en ce que** la zone de porte interne (IG) est partiellement disposée sous la zone de source (S), et est dopée suivant un autre type de dopage que la zone de source (S), ladite zone de source (S) s'étendant avec son dopage jusque dans la zone de porte interne (IG) et compensant ainsi partiellement le dopage contraire de celle-ci.

10. Structure de semi-conducteur selon l'une quelconque des revendications précédentes, **caractérisée en ce que** le substrat semi-conducteur (HK) est en silicium.

11. Structure de semi-conducteur selon l'une quelconque des revendications précédentes, **caractérisée en ce que** la zone d'extinction de drain (DCG), le contact à barrière (B) et / ou la zone de porte externe (G) sont au moins partiellement en métal ou en polysilicium.

12. Structure de semi-conducteur selon l'une quelconque des revendications précédentes, **caractérisée en ce que :**
a) le substrat semi-conducteur (HK) est faiblement dopé suivant un premier type de dopage (n⁻) ou suivant un deuxième type de dopage (p⁻) et / ou
b) la zone de drain (D) est fortement dopée suivant le deuxième type de dopage (p⁺) et / ou
c) la zone de source (S) est fortement dopée suivant le deuxième type de dopage (p⁺) et / ou
d) la zone de porte interne (IG) est dopée suivant le premier type de dopage (n⁻) et / ou
e) le contact d'extinction (CL) est disposé dans le substrat semi-conducteur (HK), contre la face avant (VS) de celui-ci et est fortement dopé suivant le premier type de dopage (n⁺) et / ou
f) la première zone de blindage (SSH) est dopée suivant le deuxième type de dopage (p) et / ou
g) la deuxième zone de blindage (CSH) est dopée suivant le deuxième type de dopage (p) et / ou
h) une zone (RK) du deuxième type de dopage (p) est disposée contre la face arrière (RS) du substrat semi-conducteur (HK), pour appauvrir le substrat semi-conducteur (HK).

13. Structure de semi-conducteur selon la revendication 12, **caractérisée en ce que** le premier type de dopage est dopé n, alors que le deuxième type de dopage est dopé p.

14. Structure de semi-conducteur selon la revendication 12, **caractérisée en ce que** le premier type de dopage est dopé p alors que le deuxième type de dopage est dopé n.

15. Détecteur à semi-conducteur avec une structure de semi-conducteur selon l'une quelconque des revendications précédentes.

16. Procédé de fonctionnement pour un détecteur à semi-conducteur selon l'une quelconque des revendications précédentes, comprenant les étapes suivantes (S3, S6, S7) dans un ordre quelconque :
a) détection de rayonnement dans un état de sensibilité du détecteur à semi-conducteur, ledit rayonnement générant des porteurs de charge de signal dans un substrat semi-conducteur (HK) du détecteur à semi-conducteur, lesquels sont accumulés dans une zone de porte interne (IG) du substrat semi-conducteur (HK),
b) mesure des porteurs de charge de signal accumulés dans la zone de porte interne (IG), en tant que mesure du rayonnement détecté,
c) extinction par un contact d'extinction (CL) des porteurs de charge de signal accumulés dans la zone de porte interne (IG),
d) réglage d'un état d'insensibilité du détecteur à semi-conducteur, où des porteurs de charge de signal générés par le rayonnement sont évacués par le contact d'extinction (CL), alors que les porteurs de charge de signal déjà accumulés dans la zone de porte interne (IG) y restent maintenus.

17. Procédé de fonctionnement selon la revendication 16, **caractérisé en ce qu'**une barrière de potentiel est générée au moyen du contact à barrière (B) entre la zone de porte interne (IG) et le contact d'extinction (CL) en état d'insensibilité du détecteur à semi-conducteur, ladite barrière de potentiel empêchant que les porteurs de charge de signal accumulés dans la zone de porte interne (IG) soient aspirés par le contact d'extinction (CL).

18. Procédé de fonctionnement selon la revendication 17, **caractérisé en ce que :**
a) un potentiel négatif est appliqué sur le contact de barrière (B) en état d'insensibilité, pour générer la barrière de potentiel entre la zone de porte interne (IG) et le contact d'extinction (CL), et
b) le potentiel du contact de barrière (B) pour l'extinction des porteurs de charge de signal accumulés dans la zone de porte interne (IG) est déplacé en direction positive, pour supprimer la barrière de potentiel et permettre une aspiration des porteurs de charge de signal accumulés dans la zone de porte interne (IG).

19. Procédé de fonctionnement selon l'une quelconque des revendications 16 à 18, **caractérisé en ce que**, lors de la mesure des porteurs de charge de signal accumulés dans la zone de porte interne (IG), un courant passant par une canalisation de ligne (K) entre une zone de source (S) et une zone de drain (D) dans le substrat semi-conducteur (HK) est mesuré, le courant mesuré étant commandé par les porteurs de charge de signal accumulés dans la zone de porte interne (IG) et par une zone de porte externe (G).

20. Procédé de fonctionnement la revendication 19, **caractérisé en ce qu'**un potentiel est appliqué sur la zone de porte externe (G) en état de sensibilité, tel que le courant passant par la canalisation de ligne (K) est bloqué.

21. Procédé de fonctionnement selon l'une quelconque des revendications 16 à 20, **caractérisé en ce qu'**un potentiel positif est appliqué sur le contact d'extinction (CL) pendant l'extinction et en état d'insensibilité.

22. Procédé de fonctionnement selon l'une quelconque des revendications 16 à 21, **caractérisé en ce qu'**une zone d'extinction de drain (DCG) située sur la face avant (VS) du substrat semi-conducteur (HK) est excitée pour la commutation entre l'état d'insensibilité et l'état de sensibilité, laquelle permet en option la dérivation de la charge de signal générée vers le contact d'extinction (CL) ou la formation d'une couche d'inversion raccordée à la zone de drain (D).

23. Procédé de fonctionnement selon la revendication 22, **caractérisé en ce que** la zone d'extinction de drain (DCG) est excitée avec un potentiel négatif en état de sensibilité, et avec un potentiel positif en état d'insensibilité.

24. Procédé de fonctionnement selon l'une quelconque des revendications 16 à 23, **caractérisé par** la séquence suivante pour la détection du rayonnement incident pendant une période de détection définie :
a) extinction des porteurs de charge de signal accumulés dans la zone de porte interne (IG) jusqu'au commencement de la période de détection,
b) détection du rayonnement incident pendant la période de détection,
c) réglage de l'état d'insensibilité à la fin de la période de détection,
d) mesure du courant entre la zone de source (S) et la zone de drain (D), en tant que mesure pour les porteurs de charge de signal accumulés dans la zone de porte (IG),
e) extinction des porteurs de charge de signal accumulés dans la zone de porte interne (IG),
f) mesure du courant entre la zone de source (S) et la zone de drain (D), en tant que grandeur de référence,
g) calcul de la différence entre les deux courants mesurés.
